(19) 〔Europäisches Patentamt / European Patent Office / Office européen des brevets〕

(11) **EP 1 857 426 A1**

(12) # EUROPEAN PATENT APPLICATION
published in accordance with Art. 158(3) EPC

(43) Date of publication:
**21.11.2007 Bulletin 2007/47**

(21) Application number: **06714321.4**

(22) Date of filing: **22.02.2006**

(51) Int Cl.:
*C04B 35/491* (2006.01)     *H01L 41/187* (2006.01)

(86) International application number:
**PCT/JP2006/303181**

(87) International publication number:
**WO 2006/093002 (08.09.2006 Gazette 2006/36)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **01.03.2005   JP 2005055270**

(71) Applicants:
• **IBIDEN CO., LTD.**
**Ogaki-shi, Gifu 503-8604 (JP)**
• **Dai Nippon Toryo Co., Ltd.**
**Osaka-City,**
**Osaka 554-0012 (JP)**

(72) Inventors:
• **ITO, Atsushi**
**i-gun, Gifu, 5010601 (JP)**

• **MATSUNO, Yoshiya**
**i-gun, Gifu, 5010601 (JP)**
• **SHIKANO, Haruhide**
**i-gun, Gifu, 5010601 (JP)**
• **IDO, Takahiko**
**i-gun, Gifu, 5010601 (JP)**
• **MATSUYAMA, Takuo**
**Konohana-ku, Osaka-shi, Osaka, 5540012 (JP)**
• **FUKUYASU, Shigeo**
**Konohana-ku, Osaka-shi, Osaka, 5540012 (JP)**
• **UENO, Masakazu**
**Konohana-ku, Osaka-shi, Osaka, 5540012 (JP)**

(74) Representative: **Dossmann, Gérard**
**Bureau Casalonga & Josse**
**Bayerstrasse 71/73**
**80335 München (DE)**

(54) **PIEZOELECTRIC PORCELAIN COMPOSITION**

(57)     The present invention provides a piezoelectric ceramic composition, for producing piezoelectric elements exhibiting high piezoelectric strain constant $d_{33}$ and high Curie temperature Tc, which composition includes a perovskite $PbZrO_3$ (a), a perovskite $PbTiO_3$ (b), SrO (c), $Nb_2O_5$ (d) and ZnO (e), and relative amounts of the components (a), (b), (c), (d) and (e) satisfy the general formula:

$$Pb(Zr_aTi_{1-a})O_3 + bSrO + cNbO_{2.5} + dZnO$$

wherein $0.51 \leq a \leq 0.54$; $1.1 \times 10^{-2} \leq b \leq 6.0 \times 10^{-2}$; $0.9 \times 10^{-2} \leq c \leq 4.25 \times 10^{-2}$; $0.1 \times 10^{-2} \leq d \leq 1.25 \times 10^{-2}$; and $2.9 \leq c/d \leq 15.0$.

**EP 1 857 426 A1**

**Description**

Technical Field

The present invention relates to a piezoelectric ceramic composition and, more particularly, to a piezoelectric ceramic composition exhibiting high piezoelectric strain constant $d_{33}$ and high Curie temperature Tc.

Background Art

Hitherto, piezoelectric devices such as ultrasonic vibrators, sound generators, actuators, and sensors have employed piezoelectric elements produced from a piezoelectric ceramic composition. In such devices, there is demand for improving piezoelectric characteristics of the piezoelectric ceramic composition so as to reduce dimensions of piezoelectric devices and enhance energy conversion efficiency.

As used herein, the term "piezoelectric characteristics" refers to generation of strain through application of mechanical stress to an piezoelectric element, resulting in electric polarization, or generation of strain proportional to electric polarization through application of an electric field to a piezoelectric element. In order to evaluate piezoelectric characteristics, piezoelectric strain constant $d_{33}$ or a similar parameter, which is a material constant of piezoelectric elements and serves as an index for piezoelectric effect, is determined. For producing a piezoelectric device, for example, an ultrasonic vibrator, a piezoelectric ceramic composition exhibiting high piezoelectric strain constant $d_{33}$ is advantageously employed, since electro-mechanical energy conversion efficiency is enhanced with an increase in piezoelectric strain constant $d_{33}$.

In recent years, piezoelectric elements are not only employed in apparatuses for use at room temperature, but also in apparatuses for use under severe (high-temperature) conditions. Thus, reliability of piezoelectric elements under high-temperature conditions is demanded. In order to evaluate high-temperature characteristics, Curie temperature Tc, which is another material constant of piezoelectric elements and serves as an index for heat-resistant effect, is employed. The higher the Curie temperature Tc, the more effective the prevention of depolarization under high-temperature conditions. Therefore, a piezoelectric ceramic composition exhibiting high Curie temperature Tc finds uses which must exhibit stability in characteristics under high-temperature conditions.

As mentioned above, in order to reduce dimensions of piezoelectric devices and enhance energy conversion efficiency, the piezoelectric strain constant $d_{33}$ of piezoelectric elements must be increased, whereas Curie temperature Tc of piezoelectric elements must be elevated in order to improve high-temperature characteristics and stability in characteristics under high-temperature conditions. Therefore, in recent years, there has been a demand for a piezoelectric ceramic composition for constituting piezoelectric elements, which composition exhibits satisfactory piezoelectric strain constant $d_{33}$ and Curie temperature Tc, and a variety of piezoelectric ceramic compositions have been proposed (see, for example, Patent Documents 1 and 2).

Patent Document 1: Japanese Patent Application Laid-Open (kokai) No. 2000-327418Patent Document 2: Japanese Patent Application Laid-Open (kokai) No. 2001-097774

Disclosure of the Invention

Problems to be Solved by the Invention

The present invention has been completed considering the fact of the aforementioned prior art. Thus, an object of the present invention is to provide a piezoelectric ceramic composition for constituting piezoelectric elements, which composition exhibits high piezoelectric strain constant $d_{33}$ and high Curie temperature Tc.

Means for Solving the Problems

The present inventors have conducted extensive studies in order to attain the aforementioned object, and have found that incorporating specific amounts of SrO, $Nb_2O_5$, and ZnO into a $PbZrO_3$-$PbTiO_3$ composition enables production of a piezoelectric ceramic composition for constituting piezoelectric elements, which composition exhibits high piezoelectric strain constant $d_{33}$ and high Curie temperature Tc. The present invention has been accomplished on the basis of this finding.

Accordingly, the piezoelectric ceramic composition of the present invention comprises a perovskite $PbZrO_3$ (a), a perovskite $PbTiO_3$ (b), SrO (c), $Nb_2O_5$ (d) and ZnO (e), and relative amounts of the components (a), (b), (c), (d) and (e) satisfy the general formula:

2

$$Pb(Zr_aTi_{1-a})O_3 + bSrO + cNbO_{2.5} + dZnO$$

wherein $0.51 \leq a \leq 0.54$; $1.1 \times 10^{-2} \leq b \leq 6.0 \times 10^{-2}$; $0.9 \times 10^{-2} \leq c \leq 4.25 \times 10^{-2}$; $0.1 \times 10^{-2} \leq d \leq 1.25 \times 10^{-2}$; and $2.9 \leq c/d \leq 15.0$.

Effects of the Invention

Since the piezoelectric ceramic composition of the present invention has specific compositonal proportions, the piezoelectric strain constant $d_{33}$ and Curie temperature Tc of the composition are high. Therefore, the composition is suitable for producing piezoelectric elements such as ultrasonic vibrators, sound generators, and actuators. Best Modes for Carrying Out the Invention

The piezoelectric ceramic composition of the present invention will next be described in more detail.

As understood from the data obtained in the Examples and Comparative Examples shown hereinbelow, in the piezoelectric ceramic composition of the present invention, relative amounts of the components (a), (b), (c), (d) and (e) satisfy the general formula:

$$Pb(Zr_aTi_{1-a})O_3 + bSrO + cNbO_{2.5} + dZnO$$

wherein, preferably $0.51 \leq a \leq 0.54$; $1.1 \times 10^{-2} \leq b \leq 6.0 \times 10^{-2}$; $0.9 \times 10^{-2} \leq c \leq 4.25 \times 10^{-2}$; $0.1 \times 10^{-2} \leq d \leq 1.25 \times 10^{-2}$; and $2.9 \leq c/d \leq 15.0$, and more preferably, $0.52 \leq a \leq 0.54$; $1.2 \times 10^{-2} \leq b \leq 5.0 \times 10^{-2}$; $1.0 \times 10^{-2} \leq c \leq 4.0 \times 10^{-2}$; $0.2 \times 10^{-2} \leq d \leq 1.0 \times 10^{-2}$; and $3.0 \leq c/d \leq 13.0$.

Piezoelectric elements produced from the piezoelectric ceramic composition of the present invention, satisfying the aforementioned conditions, exhibit desired high piezoelectric strain constant $d_{33}$ and Curie temperature Tc; e.g., a piezoelectric strain constant $d_{33}$ higher than 400 pC/N and a Curie temperature Tc higher than 300°C.

However, when in the general formula:

$$Pb(Zr_aTi_{1-a})O_3 + bSrO + cNbO_{2.5} + dZnO$$

"a" is smaller than 0.51 or greater than 0.54, piezoelectric elements produced from such a piezoelectric ceramic composition tend to exhibit low piezoelectric strain constant $d_{33}$, which is not preferred. Thus, in the piezoelectric ceramic composition of the present invention, "a" preferably satisfies $0.51 \leq a \leq 0.54$, and more preferably $0.52 \leq a \leq 0.54$.

When "b" is smaller than $1.1 \times 10^{-2}$, piezoelectric elements produced from such a piezoelectric ceramic composition tend to exhibit low piezoelectric strain constant $d_{33}$, which is not preferred. When "b" is greater than $6.0 \times 10^{-2}$, piezoelectric elements produced from such a piezoelectric ceramic composition tend to exhibit low Curie temperature Tc, which is not preferred. Thus, in the piezoelectric ceramic composition of the present invention, "b" preferably satisfies $1.1 \times 10^{-2} \leq b \leq 6.0 \times 10^{-2}$, and more preferably, $1.2 \times 10^{-2} \leq b \leq 5.0 \times 10^{-2}$.

When "c" is smaller than $0.9 \times 10^{-2}$, piezoelectric elements produced from such a piezoelectric ceramic composition tend to exhibit low piezoelectric strain constant $d_{33}$, which is not preferred. When "c" is greater than $4.25 \times 10^{-2}$, piezoelectric elements produced from such a piezoelectric ceramic composition tend to exhibit low Curie temperature Tc, which is not preferred. Thus, in the piezoelectric ceramic composition of the present invention, "c" preferably satisfies $0.9 \times 10^{-2} \leq c \leq 4.25 \times 10^{-2}$, and more preferably, $1.0 \times 10^{-2} \leq c \leq 4.0 \times 10^{-2}$.

When "d" is smaller than $0.1 \times 10^{-2}$, piezoelectric elements produced from such a piezoelectric ceramic composition tend to exhibit low piezoelectric strain constant $d_{33}$, which is not preferred. When "d" is greater than $1.25 \times 10^{-2}$, piezoelectric elements produced from such a piezoelectric ceramic composition tend to exhibit low Curie temperature Tc, which is not preferred. Thus, in the piezoelectric ceramic composition of the present invention, "d" preferably satisfies $0.1 \times 10^{-2} \leq d \leq 1.25 \times 10^{-2}$, and more preferably, $0.2 \times 10^{-2} \leq d \leq 1.0 \times 10^{-2}$.

Even when the conditions $0.9 \times 10^{-2} \leq c \leq 4.25 \times 10^{-2}$ and $0.1 \times 10^{-2} \leq d \leq 1.25 \times 10^{-2}$ are satisfied, in the case where the c/d value is smaller than 2.9 or greater than 15.0, piezoelectric elements produced from such a piezoelectric ceramic composition tend to exhibit low piezoelectric strain constant $d_{33}$, which is not preferred. Thus, in the piezoelectric ceramic composition of the present invention, "c/d" preferably satisfies $2.9 \leq c/d \leq 15.0$, and more preferably, $3.0 \leq c/d \leq 13.0$.

The piezoelectric ceramic composition of the present invention may be produced through any of a variety of methods. For example, the following production method may be employed.

First, a Pb component, a Zr component, a Ti component, an Sr component, a Zn component, and an Nb component of a starting material, each in powder form, are weighed to provide required amounts thereof, and the starting material powders are mixed and pulverized by means of a pulverizer such as a ball mill. Mixing and pulverization are preferably performed in a wet process in the presence of water in order to attain uniformity in the process. When the wet process is employed, water is incorporated into the mixture in an amount of 50 to 75% based on the total mass, preferably 60 to 70%. No particular limitation is imposed on the time for mixing and pulverization, so long as uniform mixing and pulverization can be satisfactorily attained. For example, the process is performed for 5 to 30 hours, preferably 10 to 20 hours. After drying, the thus-formed powder mixture is generally calcinated in an oxidizing atmosphere such as the atmosphere at 700 to 1,000°C, preferably at 800 to 900°C for 1 to 7 hours, preferably for 2 to 5 hours.

No particular limitation is imposed on the type of the Pb component employed in the aforementioned production method so long as the Pb component can form lead oxide through firing, and a variety of Pb components may be employed. Examples of the Pb component include lead oxides such as $Pb_3O_4$ (red lead) and PbO.

No particular limitation is imposed on the type of the Zr component employed in the aforementioned production method so long as the Zr component can form zirconium oxide through firing, and a variety of zirconium components may be employed. Examples of the Zr component include zirconium oxides such as zirconium dioxide, and zirconium hydroxide.

No particular limitation is imposed on the type of the Ti component employed in the aforementioned production method so long as the Ti component can form titanium oxide through firing, and a variety of titanium components may be employed. Examples of the Ti component include titanium oxides such as titanium dioxide, and titanium hydroxide.

No particular limitation is imposed on the type of the Sr component employed in the aforementioned production method so long as the Sr component can form strontium oxide through firing, and a variety of strontium components may be employed. Examples of the Sr component include strontium oxide and strontium carbonate.

No particular limitation is imposed on the type of the Nb component employed in the aforementioned production method so long as the Nb component can form niobium oxide through firing, and a variety of niobium components may be employed. Examples of the Nb component include niobium oxides such as diniobium pentoxide.

No particular limitation is imposed on the type of the Zn component employed in the aforementioned production method so long as the Zn component can form zinc oxide through firing, and a variety of zinc components may be employed. Examples of the Zn component include zinc oxide, zinc hydroxide, zinc nitrate, and zinc carbonate. Of these, zinc oxide is preferably employed.

These metallic components are formulated in such relative amounts, atomic proportion, of Pb component, Zr component, Ti component, Sr component, Nb component and Zn component that, the general formula:

$$Pb(Zr_aTi_{1-a})O_3 + bSrO + cNbO_{2.5} + dZnO$$

satisfies the following conditions: $0.51 \leq a \leq 0.54$; $1.1 \times 10^{-2} \leq b \leq 6.0 \times 10^{-2}$; $0.9 \times 10^{-2} \leq c \leq 4.25 \times 10^{-2}$; $0.1 \times 10^{-2} \leq d \leq 1.25 \times 10^{-2}$; and $2.9 \leq c/d \leq 15.0$, and preferably the following conditions: $0.52 \leq a \leq 0.54$; $1.2 \times 10^{-2} \leq b \leq 5.0 \times 10^{-2}$; $1.0 \times 10^{-2} \leq c \leq 4.0 \times 10^{-2}$; $0.2 \times 10^{-2} \leq d \leq 1.0 \times 10^{-2}$; and $3.0 \leq c/d \leq 13.0$.

Under the aforementioned conditions, the Pb component, Zr component, Ti component, Sr component, Nb component and Zn component are mixed and pulverized, and the powder mixture is calcinated, whereby a calcination product containing a perovskite $PbZrO_3$ (a), a perovskite $PbTiO_3$ (b), SrO (c), $Nb_2O_5$ (d) and ZnO (e) is yielded.

The thus-yielded calcination product was pulverized by means of a pulverizer such as a ball mill so as to form a powder mixture generally having a mean particle size of 0.1 to 2.0 μm, preferably 0.1 to 1.0 μm. The pulverization is preferably performed in a wet process in the presence of water in order to attain uniformity in the process. The amount of water employed in pulverization is preferably 50 to 75% based on the total mass, and more preferably 60 to 70%. No particular limitation is imposed on the pulverization time so long as the time is enough to attain sufficiently uniform pulverization. For example, the pulverization time is 5 to 30 hours, preferably 10 to 20 hours. After pulverization, the formed powder is dried.

To the thus-pulverized product, for example, a binder resin such as polyvinyl alcohol is added, and the formed mixture is press-molded to a bulk form, a sheet form, etc. The molded product is fired, to thereby produce a piezoelectric element from the piezoelectric ceramic composition of the present invention. Alternatively, a piezoelectric element may also be formed from the piezoelectric ceramic composition of the present invention through stacking molded sheets of the powder, attaching an electrode between the stacked layers, and firing.

By virtue of the compositional characteristics, the piezoelectric ceramic composition of the present invention can be produced through firing at 1,050 to 1,250°C, and preferably at 1,100 to 1,200°C for 1 to 8 hours, preferably for 2 to 5 hours.

Examples

The present invention will next be described in more detail.

<Examples 1 to 17 and Comparative Examples 1 to 10>

Starting powders of PbO, TiO$_2$, ZrO$_2$, SrO, Nb$_2$O$_5$ and ZnO were weighed so that the compositional proportions shown in Table 1 were realized. Each of "a," "b," "c," and "d" in Table 1 represents a metal atomic ratio in the following compositional formula:

$$Pb\ (Zr_a Ti_{1-a})\ O_3 + bSrO + cNbO_{2.5} + dZnO.$$

In each of the Examples and Comparative Examples, these starting powders were placed in a ball mill, and water was added to the mixture so that the water content was adjusted to 65% based on the total mass. The powder mixture and water were mixed for 20 hours in a wet process. After drying, the dried product was calcined in a firing pot at 850°C. The calcined powder was pulverized for 20 hours by means of a ball mill, followed by drying.

A binder (polyvinyl alcohol) was added to the thus-pulverized powder with mixing, and the mixture was press-molded at 100 MPa by means of a press machine. The formed compact was fired at 1,200°C for two hours, to thereby yield a sintered compact.

Subsequently, electrodes were attached to the sintered compact through baking, and the resultant product was polarized at 4 kV/mm. Piezoelectric strain constant d$_{33}$ (pC/N) and Curie temperature Tc (°C) of the thus-produced piezoelectric ceramic composition were determined. The results are shown in Table 1.

With an aim to clarify preferred compositional proportions of starting powders of PbO, TiO$_2$, ZrO$_2$, SrO, Nb$_2$O$_5$ and ZnO on the basis of the Examples and Comparative Examples, in Table 1, data of metal atomic ratio parameters of "a," "b," "c," "d," and "c/d" in

$$Pb\ (Zr_a Ti_{1-a})\ O_3 + bSrO + cNbO_{2.5} + dZnO$$

are shown, with the data of Example 3 and those of Example 13 being given twice in two separate rows, for the sake of easy understanding of preferred ranges of the parameters.

[Table 1]

|  | a | b × 10² | c × 10² | d × 10² | c/d | d$_{33}$ | Tc |
|---|---|---|---|---|---|---|---|
| Comp. EX. 1 | 0.49 | 2.0 | 1.50 | 0.5 | 3.0 | 380 | 345 |
| Ex. 1 | 0.51 | 2.0 | 1.50 | 0.5 | 3.0 | 400 | 345 |
| Ex. 2 | 0.52 | 2.0 | 1.50 | 0.5 | 3.0 | 410 | 345 |
| Ex. 3 | 0.53 | 2.0 | 1.50 | 0.5 | 3.0 | 430 | 340 |
| Ex. 4 | 0.54 | 2.0 | 1.50 | 0.5 | 3.0 | 400 | 340 |
| Comp. Ex. 2 | 0.55 | 2.0 | 1.50 | 0.5 | 3.0 | 360 | 335 |
| Comp. Ex. 3 | 0.53 | 1.0 | 1.50 | 0.5 | 3.0 | 380 | 350 |
| Ex. 5 | 0.53 | 1.1 | 1.50 | 0.5 | 3.0 | 400 | 345 |
| Ex. 6 | 0.53 | 1.2 | 1.50 | 0.5 | 3.0 | 410 | 345 |
| Ex. 3 | 0.53 | 2.0 | 1.50 | 0.5 | 3.0 | 430 | 340 |
| Ex. 7 | 0.53 | 5.0 | 1.50 | 0.5 | 3.0 | 430 | 310 |
| Ex. 8 | 0.53 | 6.0 | 1.50 | 0.5 | 3.0 | 430 | 300 |
| Comp. Ex. 4 | 0.53 | 7.0 | 1.50 | 0.5 | 3.0 | 430 | 290 |

(continued)

|  | a | b × 10² | c × 10² | d × 10² | c/d | d₃₃ | Tc |
|---|---|---|---|---|---|---|---|
| Comp. Ex. 5 | 0.53 | 2.0 | 0.75 | 0.25 | 3.0 | 370 | 355 |
| Ex. 9 | 0.53 | 2.0 | 0.90 | 0.25 | 3.6 | 400 | 350 |
| Ex. 10 | 0.53 | 2.0 | 1.50 | 0.25 | 6.0 | 420 | 345 |
| Ex. 11 | 0.53 | 2.0 | 3.75 | 0.25 | 15.0 | 410 | 330 |
| Ex. 12 | 0.53 | 2.0 | 4.25 | 0.30 | 14.2 | 410 | 300 |
| Comp. Ex. 6 | 0.53 | 2.0 | 4.50 | 0.30 | 15.0 | 410 | 295 |
| Comp. Ex. 7 | 0.53 | 2.0 | 1.20 | 0.08 | 15.0 | 370 | 360 |
| Ex. 13 | 0.53 | 2.0 | 1.50 | 0.10 | 15.0 | 400 | 345 |
| Ex. 14 | 0.53 | 2.0 | 3.75 | 0.50 | 7.5 | 420 | 310 |
| Ex. 15 | 0.53 | 2.0 | 3.75 | 1.25 | 3.0 | 430 | 300 |
| Comp. Ex. 8 | 0.53 | 2.0 | 3.75 | 1.30 | 2.9 | 400 | 295 |
| Comp. Ex. 9 | 0.53 | 2.0 | 1.50 | 0.60 | 2.5 | 300 | 345 |
| Ex.16 | 0.53 | 2.0 | 1.50 | 0.52 | 2.9 | 400 | 345 |
| Ex.17 | 0.53 | 2.0 | 1.50 | 0.30 | 5.0 | 420 | 345 |
| Ex. 13 | 0.53 | 2.0 | 1.50 | 0.10 | 15.0 | 400 | 345 |
| Comp. Ex. 10 | 0.53 | 2.0 | 1.60 | 0.10 | 16.0 | 390 | 340 |

As is clear from the date shown in Table 1, all the piezoelectric elements produced from piezoelectric ceramic compositions of Examples 1 to 17, falling within the scope of the invention, exhibit high piezoelectric strain constant $d_{33}$ and high Curie temperature Tc.

However, as is clean from the data of Comparative Example 1, when "a" is less than 0.51, piezoelectric strain Example 1, when "a" is less than 0.51, piezoelectric strain constant $d_{33}$ disadvantageously decreases. As is clean from the data of Comparative Example 2, when "a" is greater than 0.54, piezoelectric strain constant $d_{33}$ also disadvantageously decreases.

As is clean from the data of Comparative Example 3, when "b" is less than $1.1 \times 10^{-2}$, piezoelectric strain constant $d_{33}$ disadvantageously decreases. As is clean from the data of Comparative Example 4, when "b" is greater than $6.0 \times 10^{-2}$, Curie temperature Tc is disadvantageously lowered.

As is clean from the data of Comparative Example 5, when "c" is less than $0.9 \times 10^{-2}$, piezoelectric strain constant $d_{33}$ disadvantageously decreases. As is clean from the data of Comparative Example 6, when "c" is greater than $4.25 \times 10^{-2}$, Curie temperature Tc is disadvantageously lowered.

As is clean from the data of Comparative Example 7, when "d" is less than $0.1 \times 10^{-2}$, piezoelectric strain constant $d_{33}$ disadvantageously decreases. As is clean from the data of Comparative Example 8, when "d" is greater than $1.25 \times 10^{-2}$, Curie temperature Tc is disadvantageously lowered.

Furthermore, as is clean from the data of Comparative Example 9, even when "c" satisfies the condition: $0.9 \times 10^{-2} \leq c \leq 4.25 \times 10^{-2}$ and "d" satisfies the condition: $0.1 \times 10^{-2} \leq d \leq 1.25 \times 10^{-2}$, in the case where the c/d value is smaller than 2.9, piezoelectric strain constant $d_{33}$ disadvantageously decreases. Furthermore, as is clean from the data of Comparative Example 10, even when "c" satisfies the condition: $0.9 \times 10^{-2} \leq c \leq 4.25 \times 10^{-2}$ and "d" satisfies the condition: $0.1 \times 10^{-2} \leq d \leq 1.25 \times 10^{-2}$, in the case where the c/d value is greater than 15.0, piezoelectric strain constant $d_{33}$ disadvantageously decreases.

**Claims**

1. A piezoelectric ceramic composition **characterized in that** the composition comprises a perovskite $PbZrO_3$ (a), a perovskite $PbTiO_3$ (b), SrO (c), $Nb_2O_5$ (d) and ZnO (e), and relative amounts of the components (a), (b), (c), (d) and (e) satisfy the general formula:

$$Pb(Zr_aTi_{1-a})O_3 + bSrO + cNbO_{2.5} + dZnO$$

wherein $0.51 \leq a \leq 0.54$; $1.1 \times 10^{-2} \leq b \leq 6.0 \times 10^{-2}$; $0.9 \times 10^{-2} \leq c \leq 4.25 \times 10^{-2}$; $0.1 \times 10^{-2} \leq d \leq 1.25 \times 10^{-2}$; and $2.9 \leq c/d \leq 15.0$.

2. A piezoelectric ceramic composition as described in claim 1, wherein relative amounts of the components (a), (b), (c), (d) and (e) satisfy the general formula:

$$Pb(Zr_aTi_{1-a})O_3 + bSrO + cNbO_{2.5} + dZnO$$

wherein $0.52 \leq a \leq 0.54$; $1.2 \times 10^{-2} \leq b \leq 5.0 \times 10^{-2}$; $1.0 \times 10^{-2} \leq c \leq 4.0 \times 10^{-2}$; $0.2 \times 10^{-2} \leq d \leq 1.0 \times 10^{-2}$; and $3.0 \leq c/d \leq 13.0$.

<table>
<tr><td colspan="2" align="center">**INTERNATIONAL SEARCH REPORT**</td><td colspan="2">International application No.<br><br>PCT/JP2006/303181</td></tr>
</table>

| A. CLASSIFICATION OF SUBJECT MATTER |
|---|
| *C04B35/491*(2006.01), *H01L41/187*(2006.01) |
| |
| According to International Patent Classification (IPC) or to both national classification and IPC |

| B. FIELDS SEARCHED |
|---|
| Minimum documentation searched (classification system followed by classification symbols) |
| C04B35/491, H01L41/187 |
| |
| Documentation searched other than minimum documentation to the extent that such documents are included in the fields searched |
| Jitsuyo Shinan Koho    1922-1996   Jitsuyo Shinan Toroku Koho   1996-2006 |
| Kokai Jitsuyo Shinan Koho   1971-2006   Toroku Jitsuyo Shinan Koho   1994-2006 |
| Electronic data base consulted during the international search (name of data base and, where practicable, search terms used) |
| CAplus(STN), Science Direct |

| C. DOCUMENTS CONSIDERED TO BE RELEVANT | | |
|---|---|---|
| Category* | Citation of document, with indication, where appropriate, of the relevant passages | Relevant to claim No. |
| X | JP 2002-114571 A (Kyocera Corp.),<br>16 April, 2002 (16.04.02),<br>Claims 1, 2; Par. Nos. [0033], [0034], [0040],<br>[0056]<br>(Family: none) | 1,2 |
| A | JP 2001-278661 A (Kyocera Corp.),<br>10 October, 2001 (10.10.01),<br>Claims 1, 2; Par. Nos. [0027], [0046], [0057]<br>(Family: none) | 1,2 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>10 April, 2006 (10.04.06) | Date of mailing of the international search report<br>18 April, 2006 (18.04.06) |
|---|---|
| Name and mailing address of the ISA/<br>Japanese Patent Office | Authorized officer |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000327418 A

- JP 2001097774 A